# EUROPEAN PATENT SPECIFICATION

(11) **EP 3 686 619 B1**
(45) Date of publication and mention of the grant of the patent: **07.12.2022**
(21) Application number: 19154065.7
(22) Date of filing: 28.01.2019
(51) Int. Cl.: G01R 33/00, G01R 33/07

(54) **BRIDGE MAGNETIC SENSOR WITH DUMMY RESISTOR STRUCTURE**
MAGNETISCHER BRÜCKENSENSOR MIT EINER SCHEINWIDERSTANDSSTRUKTUR
CAPTEUR MAGNETIQUE EN PONT AVEC STRUCTURE DE RÉSISTANCE FACTICE

(43) Date of publication of application: 29.07.2020
(73) Proprietor: Melexis Technologies SA, 2022 Bevaix (CH)
(72) Inventor: VAN DEN MEERSSCHAUT, Daan, 8900 Ieper (BE)
(74) Representative: DenK iP bv

(56) References cited:
- WO-A1-2016/164260
- US-A1- 2008 074 108
- US-A1- 2009 108 839
- UDO AUSSERLECHNER ET AL: "Compensation of the Piezo-Hall Effect in Integrated Hall Sensors on (100)-Si", IEEE SENSORS JOURNAL, IEEE SERVICE CENTER, NEW YORK, NY, US, vol. 7, no. 11, 1 November 2007 (2007-11-01), pages 1475-1482, XP011192395, ISSN: 1530-437X, DOI: 10.1109/JSEN.2007.907039

## Description

### Field of the invention

The invention relates to the field of magnetic field sensors. More specifically it relates to the field of biasing systems of these magnetic field sensors.

### Background of the invention

Hall elements for measuring a magnetic field are well known, and are used inter alia in current sensors, or in angular position sensors, where a magnetic field (e.g. generated by a permanent magnet) is measured at several locations of the sensor device, and is converted into an angular position, as described for example in WO9854547 (published in 1998).

Hall elements are passive resistive structures and need to conduct a current before an output-signal can be retrieved from them. The term "biasing" is used for applying a voltage or current to such a structure. The term "readout" is used for retrieving a sensor signal or a sensor value from such a structure.

A basic Hall element (also referred to as "Hall plate") consist of a conducting material provided with at least four electrical contacts. To make use of the "Hall effect", a current has to flow through the element. A bias current I is supplied via two of the contacts. Two other contacts are typically placed on an equipotential line, to make the voltage difference between the sense contacts zero in the absence of a magnetic field and in the absence of an offset.

Due to process imperfections there will always be an offset present, meaning the voltage difference between the sense contacts can be non-zero even in the absence of a magnetic field. For small magnetic fields this offset can be substantially bigger than the actual useful output signal so some methods need to be applied to extract the useful signal. Current spinning is an effective way to do this. The sensing time gets divided in at least 2 phases (4 is better for 4 contact hall plates). In each phase the current is flowing in another direction.
In each phase the offset is roughly equal but the signal (due to the magnetic field) has an opposite polarity in half the phases (positive phases versus negative phases). The signal is modulated to a higher frequency and the offset remains at DC. Taking the difference of the sum of the positive phases and the sum of the negative phases gives you a signal where the offset is almost fully gone except for a smaller residual offset (due to the offset not being exactly the same in all phases) and a signal proportional to magnetic field.

The residual offset is what needs to be reduced further by improved biasing techniques. Alternatively, the offset may be modulated, and the signal may be kept at DC. In this case, taking the average of all the phases will result in a signal proportional to a magnetic field and a residual offset.

Hall plate sensors suffer from offset problems and stress sensitivity. The simplest 2 forms of biasing each have their own problems. Pure voltage biasing maximizes the sensitivity but results in a bigger offset, pure current biasing improves the offset (due to having the same current in each phase) but suffers from a lower sensitivity at low to medium-high temperatures. Temperatures may for example range between -40°C and 125°C. With current biasing the circuit gets optimized at a maximum temperature and any lower temperature will suffer from a sub-optimal sensitivity. If the maximum temperature is for example 150 °C then 125 °C would for example be medium-high. But if 125 °C is the maximum temperature, the circuit can be optimized for 125 °C, in which case for example 100 °C would be medium-high. In this last case the current will no longer be constant at a temperature higher than 125 °C. The advantages of current biasing disappear at temperatures higher than the trimmed temperature. When applying current biasing, the voltage over the plate is not exactly known, but depends on the electrical resistance of the plate. In the case of voltage biasing, the current flowing through the plate is not exactly known but is determined by the electrical resistance of the plate. This electrical resistance of the Hall plate varies with temperature and stress (e.g. through piezo-resistive effects) and constitutes another source of drift. The sensor resistance also affects the dynamic response of the sensor structure to changes in the applied biasing, as is needed when applying current spinning.

In US9638764 an electronic circuit is provided that can compensate for and correct changes in the sensitivity of a differential output signal generated by a Hall effect element that can result from stresses. The biasing method used in patent US9638764 combines the voltage biasing and current biasing and offers a quasi-constant voltage over the plates while keeping the current in each phase constant.

US2014/0103921 discloses a circuit and method for biasing a plate-shaped sensor element. The common mode is kept constant over temperature and stress. However, a separate current source is needed and using current biasing reduces the maximum sensitivity at lower temperatures.

Ausserlechner and others ("Compensation of the Piezo-Hall Effect in Integrated Hall Sensors on (100)-Si", IEEE SENSORS JOURNAL, IEEE SERVICE CENTER, NEW YORK, NY, US, vol. 7, no. 11, 1 November 2007 (2007-11-01), pages 1475-1482, XP011192395, ISSN: 1530-437X, DOI: 10.1109/JSEN.2007.907039) present a system, which continuously measures the relevant stress components, estimates the sensitivity drift, and corrects for it digitally.

Such an integrated circuit with integrated stress sensing element is also disclosed in US2009/0108839 A1. The stress sensing element comprises a first lateral resistor and a first vertical resistor. The stress sensing element is formed in the semiconductor die and is configured to indicate a level of at least one stress component within the semiconductor die.

In view of the changes in sensitivity caused by stress and temperature differences, there is a need for magnetic field sensors comprising biasing circuitry which allows to compensate for temperature changes and stress changes.

### Summary of the invention

It is an object of embodiments of the present invention to provide a magnetic field sensor comprising good biasing circuitry and a good method for biasing a magnetic field sensor.

The above objective is accomplished by a method and device according to the independent claims.

In a first aspect embodiments of the present invention relate to a bridge sensor. The bridge sensor comprises at least one dummy resistor structure, at least one sensor structure, a first regulator and a second regulator. The at least one sensor structure is a bridge magnetic sensor structure comprising two bias contacts and two sense contacts (Vn, Vp) and the at least one dummy resistor structure is a bridge resistive structure including two bias contacts (Vtop, Vbottom) and comprising i) two intermediate contacts (Vndum, Vpdum) between the two bias contacts of the bridge resistive structure or ii) one intermediate contact (Vmid) between the two bias contacts of the bridge resistive structure.

The first regulator is adapted to apply a predefined bias voltage on the bias contacts (Vtop, Vbottom) of the at least one dummy resistor structure and to apply, to one of the bias contacts of the at least one sensor structure, a current having a value equal to the one of a current flowing at the corresponding bias contact of the at least one dummy resistor structure multiplied by a predefined factor. The second regulator is adapted to regulate a dummy common mode voltage (Vcmdum) being an average voltage of voltages on the two intermediate contacts (Vndum, Vpdum) between the bias contacts (Vtop, Vbottom) of the at least one dummy resistor structure (110) or being a voltage on the intermediate contact (Vmid) between the bias contacts (Vtop, Vbottom) of the at least one dummy resistor structure (110) such that the dummy common mode voltage is the same as the common mode voltage being an average voltage of voltages on the sense contacts (Vn, Vp) of the at least one sensor structure (120).

It is an advantage of embodiments of the present invention that the dummy common mode voltage of the dummy resistor structure (having the same technology as the sensor structure; e.g. a dummy Hall plate for a Hall sensor) can be regulated to be the same as the common mode voltage of the sensor structures (e.g. sensor plates). By having the same common mode voltage, the resistivity and normalized sensitivity of the sensor structure (e.g. Hall plate) is the same as the resistivity and normalized sensitivity (i.e. sensitivity per unit of bias voltage) of the dummy resistor structure. It is advantageous that this improves the stress performance. This in comparison with a bridge sensor (e.g. Hall sensor) wherein the dummy resistor structure has a significantly different dummy common mode than the sensor structure (e.g. Hall plates). A different common mode voltage results in a difference in resistivity, normalized sensitivity, temperature and stress behavior.

It is an advantage of embodiments of the present invention that a quasi-constant voltage is applied over the sensor structures (e.g. Hall plates) over temperature. With an increased voltage level over the sensor structures an improved noise performance can be obtained. By keeping the voltage level at a quasi-constant level, it is possible to maintain the noise performance for different temperatures. The voltage over the sensor structures may for example be maximized for optimizing the noise performance.

It is an advantage of embodiments of the present invention that the current remains the same within each phase, which minimizes the residual offset of the sensor structures (e.g. hall plates).

In embodiments of the present invention the predefined scaling factor may be equal to one or at least 2 or at least 4 or at least 8. In embodiments of the present invention the at least one dummy resistor structure is made of the same material and/or using a same technology as the at least one sensor structure.

It is an advantage of embodiments of the present invention that resistivity changes due to stress are the same for the dummy resistor structure as for the at least one sensor structure (e.g. Hall plate).

It is an advantage of embodiments of the present invention that normalized sensitivity changes due to stress are the same for the dummy resistor structure as for the at least one sensor structure (e.g. Hall plate).

In embodiments of the present invention the sensor structure comprises switching circuitry adapted for spinning the sense contacts and the bias contacts.

It is an advantage of embodiments of the present invention that, as the dummy resistor structures are not switched , a stable common mode voltage can be obtained, even when spinning the sense contacts and the bias contacts of the sensor structure. A settling time may be foreseen at the beginning of each phase before measuring the common mode voltage in order to improve the stability of the common mode voltage even more.

It is moreover advantageous that a predefined bias voltage is applied on the bias contacts of the at least one dummy resistor structure and the first regulator applies to one of the bias contact of the at least one sensor structure, a current having a value equal to the one of a current flowing at the corresponding bias contact of the at least one dummy resistor structure multiplied by a predefined factor. Thus, a stable current can be achieved through the sensor structure, even when spinning the sense contacts and the bias contacts of the sensor structure.

It is an advantage of embodiments of the present invention that the dummy common mode voltage on the at least one intermediate contact of the at least one dummy resistor structure and the common mode voltage of the at least one sensor structure (e.g. sensor Hall plate) is a stable voltage.

Further embodiments of the present invention are defined according to the appended dependent claims.

It is an advantage of embodiments of the present invention that the dummy common mode voltage of the at least one dummy resistor structure (e.g. dummy Hall plate) can be obtained using an average block. In embodiments of the present invention the average block may be integrated in the second regulator. More specifically, it may be integrated in the second amplifier. In embodiments of the present invention the dummy common mode voltage is approximately the voltage between the voltage on the bias contacts (i.e. the average of the voltages Vtop and Vbottom). For example, if Vtop is 3V and Vbottom is 1V, the common mode voltage may be approximately 2V. In a typical Hall plate, the common mode voltage may be approximately the average of the top and bottom voltage, whilst smaller than the average (e.g. 1.9V instead of 2V). This may for example be caused by a resistivity of the top-half of the Hall plate which is bigger than the resistivity of the bottom-half.

In embodiments of the present invention the bridge sensor comprises a second average block which is adapted for averaging the voltages on the sense contacts (Vn, Vp) of the at least one sensor Hall plate and for outputting the obtained average and the output of the second average block is connected with an input of the second regulator.

In embodiments of the present invention the output of the second average block may be connected with the input of the third amplifier. The third amplifier thereby controls the gate of the fourth transistor such that the common mode voltage on the sense contacts of the at least one sensor structure is regulated to a predefined voltage. In embodiments of the present invention the second average block may be integrated in the second regulator (e.g. more specifically the third amplifier).

In embodiments of the present invention the predefined scaling factor is an integer larger than one.

It is an advantage of embodiments of the present invention that a smaller current can be flowing through the dummy resistor structure than through the at least one sensor structure. As, in embodiments of the present invention, the dummy resistor structure is not used for measuring the magnetic field a smaller current is allowed.

In embodiments of the present invention the dummy resistor structure comprises two or more dummy Hall plates.

These may for example be connected in parallel, or in anti-parallel. The bridge sensor may comprise two dummy Hall plates in series, wherein the intermediate contact (Vmid) is the contact in between the first and the second dummy Hall plate.

The number of sensor structures may for example be four or eight.

The at least one sensor structure may for example comprise XMR (extremely large magnetoresistance) elements configured in a bridge configuration. The bridge can for example be a bridge of at least 2 XMR elements or for example 4 XMR elements. They may be sensitive to at least one or at least 2 directions of a magnetic field.

In a second aspect embodiments of the present invention relate to a method for biasing a bridge sensor according to claim 14.

These and other aspects of the invention will be apparent from and elucidated with reference to the embodiment(s) described hereinafter.

### Brief description of the drawings

FIG. 1 shows a schematic drawing of an exemplary embodiment of the present invention comprising one dummy Hall plate and 4 sensor Hall plates.
FIG. 2 shows a similar bridge sensor as in FIG. 1, wherein the Hall plates have 8 contacts, in accordance with embodiments of the present invention.
FIG. 3 shows an implementation as in FIG. 1 which additionally comprises cascode transistors and spinning and dummy switches, in accordance with embodiments of the present invention.
FIG. 4 shows a similar implementation as FIG. 3 but without the switches, in accordance with embodiments of the present invention.
FIG. 5 shows a similar implementation as FIG. 3 but without the cascode transistors.
FIG. 6 shows a similar implementation as FIG. 5 but without the dummy switches, in accordance with embodiments of the present invention.
FIG. 7 shows a schematic drawing of an exemplary embodiment of the present invention wherein the current through the dummy Hall plate is reduced.
FIG. 8 shows a schematic drawing of an exemplary embodiment of the present invention wherein the common mode of the dummy Hall plate is regulated to the common mode of the sensing Hall plate.
FIG. 9 shows a schematic drawing of a similar implementation as in FIG. 1 except with 2 dummy hall plates in parallel instead of just 1 dummy hall plate.
FIG. 10 shows a schematic drawing of a similar implementation as in FIG. 7 except with 2 dummy hall plates in parallel instead of just 1 dummy hall plate.
FIG. 11 shows a schematic drawing of a similar implementation as in FIG. 8 except with 2 dummy hall plates in parallel instead of just 1 dummy hall plate.
FIG. 12 shows a schematic drawing of a similar implementation as in FIG. 1 except with 2 dummy hall plates in series instead of just 1 dummy hall plate.
FIG. 13 shows a schematic drawing of a similar implementation as in FIG. 7 except with 2 dummy hall plates in series instead of just 1 dummy hall plate.
FIG. 14 shows a schematic drawing of a similar implementation as in FIG. 8 except with 2 dummy hall plates in series instead of just 1 dummy hall plate.
FIG. 15 shows a regulating amplifier for a Hall sensor in accordance with embodiments of the present invention.
FIG. 16 shows a regulating amplifier adapted for averaging two inputs in accordance with embodiments of the present invention.
FIG. 17 shows 4 parallel sensor Hall plates during 1 phase for a Hall sensor in accordance with embodiments of the present invention.
FIG. 18 shows a single dummy Hall plate for a Hall sensor in accordance with embodiments of the present invention.
FIG. 19 shows two dummy Hall plates connected in parallel for a Hall sensor in accordance with embodiments of the present invention.
FIG. 20 shows two dummy Hall plates connected in anti-parallel for a Hall sensor in accordance with embodiments of the present invention.
FIG. 21 shows a Hall plate structure comprising 8 sensing Hall plates, each having 8 contacts, during 1 phase, in accordance with embodiments of the present invention.
FIG. 22 shows four dummy Hall plates, each comprising 8 contacts, connected in parallel, in accordance with embodiments of the present invention.
FIG. 23 shows four dummy Hall plates, each comprising 8 contacts, connected in anti-parallel, in accordance with embodiments of the present invention.
FIG. 24 shows a connection scheme of a dummy Hall plate comprising 8 contacts, in accordance with embodiments of the present invention.
FIG. 25 shows a connection scheme of a single sensor Hall plate comprising 8 contacts, in accordance with embodiments of the present invention.
FIG. 26 shows a schematic drawing of switching circuitry in accordance with embodiments of the present invention.
FIG. 27 shows a spatial spinning scheme, spinning the sense contacts and the bias contacts of the sensor structure, in accordance with embodiments of the present invention.
FIG. 28 shows a temporal spinning scheme, spinning the sense contacts and the bias contacts of the sensor structure, in accordance with embodiments of the present invention.

Any reference signs in the claims shall not be construed as limiting the scope. In the different drawings, the same reference signs refer to the same or analogous elements.

### Detailed description of illustrative embodiments

The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second and the like in the description and in the claims, are used for distinguishing between similar elements and not necessarily for describing a sequence, either temporally, spatially, in ranking or in any other manner.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may.

In a first aspect embodiments of the present invention relate to a bridge sensor 100. The bridge sensor comprises at least one dummy resistor structure 110 at least one sensor structure 120, a first regulator 130 and a second regulator 140.

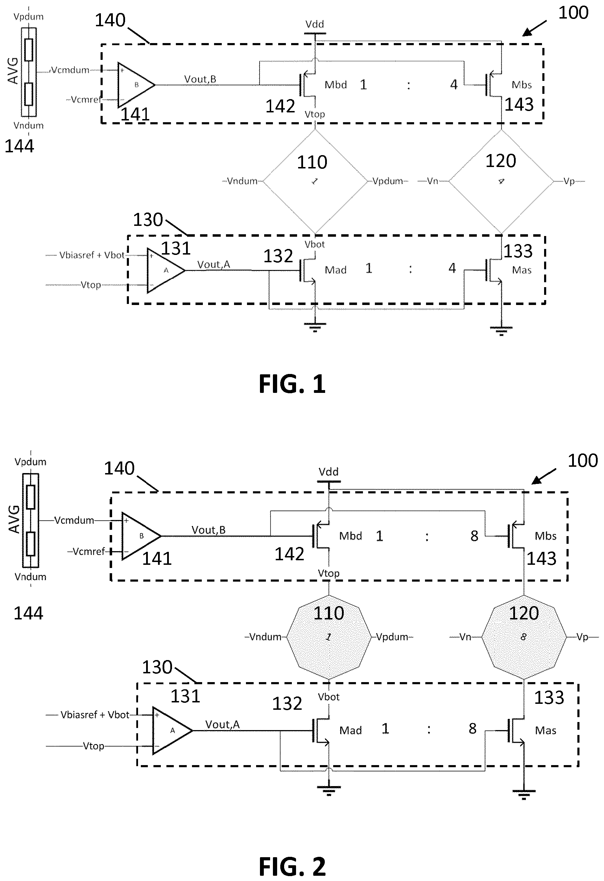

FIG. 1 shows a schematic drawing of an exemplary embodiment of the present invention. In this example there are 4 measuring Hall plates 120 and there is one dummy Hall plate 110. The dummy Hall plate may or may not be present in a magnetic field. In z-mode measurement the dummy Hall plate may for example measure the magnetic field. The voltage present over the dummy Hall plate (Vndum, Vpdum) may change, but the voltages (Vndum, Vpdum) at the terminals are only used to calculate the dummy common mode of the signal. The dummy common mode will be independent of the magnetic field. In embodiments of the present invention these terminals of the dummy Hall plate are not used for sensing. The dummy common mode voltage is obtained by taking the average of Vndum and Vpdum. This is achieved by an averaging circuitry 144 as symbolically illustrated in FIG. 1. This may for example be achieved by an amplifier of which the positive input is split in two parallel inputs. Instead of having an amplifier with two inputs, a negative input and a positive input, two positive inputs are applied and one negative. Each positive input has only half the gain as the negative one. Vpdum and Vndum are connected to the positive inputs. By doing so the reference is equal to (Vpdum+Vndum)/2.

The dummy Hall plate 110 is preferably centered around the common mode. This is achieved by Vtop. If for example the common mode reference voltage Vcmref is for example taken to be 1.5V, it will guarantee that the center of the Hall plate is 1.5V.

In the example the dummy Hall plate 110 is connected between two transistors 142, 132. In this exemplary embodiment of the present invention the configuration comprising the Hall plate and the transistors is mirrored k times (with k a natural number which is one or greater). Thus, k measurement Hall plates are obtained.

In embodiments of the present invention the second regulator 140 is adapted to regulate the dummy common mode voltage of the at least one dummy resistor structure 110 It may therefore comprise a second operational amplifier 141 or any other type of regulator for achieving this. The second operational amplifier 141 is controlled by the dummy common mode voltage and the common mode reference voltage. If, for example, the dummy common mode voltage increases above the common mode reference voltage Vcmref the gate of the third transistor 142 will be closed thereby lowering Vtop and reducing the dummy common mode voltage.

The first operational amplifier 131 is regulating the voltage over the dummy resistive structure, i.e. the voltage difference between Vtop and Vbot. Vbiasref+Vbot is applied to the positive input terminal of the second amplifier and Vtop is applied to the negative input terminal of the first operational amplifier 131. By doing so Vtop-Vbottom equals Vbiasref. The same Vbiasref will be present over the sensor Hall plate 120 and the same common mode will be present over the sensor Hall plate 120.

It is an advantage of embodiments of the present invention that the dummy Hall plate 110 and the sensor Hall plate 120 have the same common mode voltage. Thus, a same resistivity and a same normalized sensitivity of the sensor Hall plate and the dummy Hall plate can be obtained. As the resistivity of the Hall plate is not the same over the full voltage domain due to the bulk source effect, it is advantageous that during operation the Hall plates have the same common mode voltage.

In the exemplary embodiment illustrated in FIG. 1 a first transistor 132 (which in this example is an nMOS transistor) is connected at one side (e.g. the bottom side) of the dummy plate 110. In this exemplary embodiment the output of the first operational amplifier (signal Vout,A) is connected to the gate of the first transistor 132. The source of the first transistor 132 is connected to ground and the drain to one of the contacts of the hall plate 110. In the exemplary embodiment illustrated in FIG. 1 this is the bottom contact with associated signal Vbot. The invention is, however, not limited thereto (the drain may also be connected to another contact).

The dummy hall plate contact Vtop at the opposite side of the contact where the first transistor 132 is connected, is connected to the drain of a third transistor 142 (in this example this is a pMOS transistor, the invention is, however, not limited thereto. The drain of the third transistor 142 is connected to the supply and its gate is driven by a second operational amplifier 142 (signal Vout,B).

In embodiments of the present invention the negative input of the first operational amplifier 131 may be connected to Vtop-Vbot and the positive input to the voltage bias reference level Vbiasref. Another way is to connect the negative input to Vtop and the positive input to Vbiasref+Vbot. This is illustrated in FIG. 1. In FIG. 1 the first operational amplifier 131 is adapted for performing the following function:
Vout,A = Ga^{∗}(Vbiasref-(Vtop-Vbot)), with Ga a high gain (f.e. more than 60dB).

The second operational amplifier 141 is regulating the dummy common mode of the dummy hall plate 110, by regulating the average of the voltages of the intermediate contacts (sense contacts Vndum, Vpdum) to a predefined value which is the reference level Vcmref.

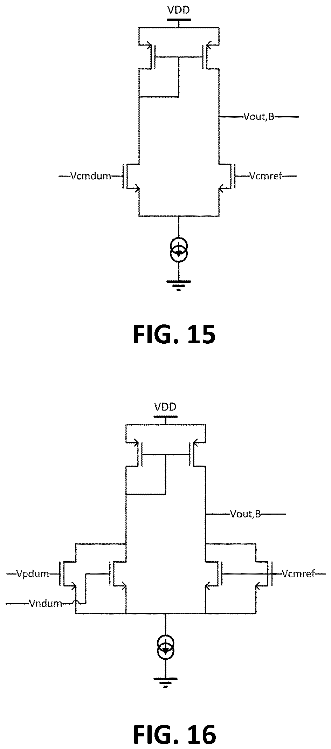

A first average block 144 takes as inputs the 2 sense contacts of the dummy Hall plate 110 (Vpdum and Vndum) and has as output the average (and thus common mode) of these signals (Vcmdum). The output is connected to the positive input of the second operational amplifier 141 and the reference level (Vcmref) is connected to the negative input. It is not necessary to have a seperate average block 144 as the combined functionality of the average block 144 and the second operational amplifier 141 can be done by a modified regulator with 2 positive inputs (Vpdum and Vndum) and 1 negative input with double weight (Vcmref). An example of such a modified regulator is illustrated in FIG. 16. In embodiments of the present invention the output of the second operational amplifier 141 performs the following function:
Vout,B = Gb^{∗}((Vpdum+Vndum)/2-Vcmref) = Gb^{∗}(Vcmdum-Vcmref), with Gb a high gain ( f.e. more than 60dB). Vcmdum thereby corresponds with (Vpdum+Vndum)/2, i.e. the average.

In embodiments of the present invention the current flowing in the dummy Hall plate 110 (or a multiple of the current) is mirrored to the at least one sensor Hall plate 120.

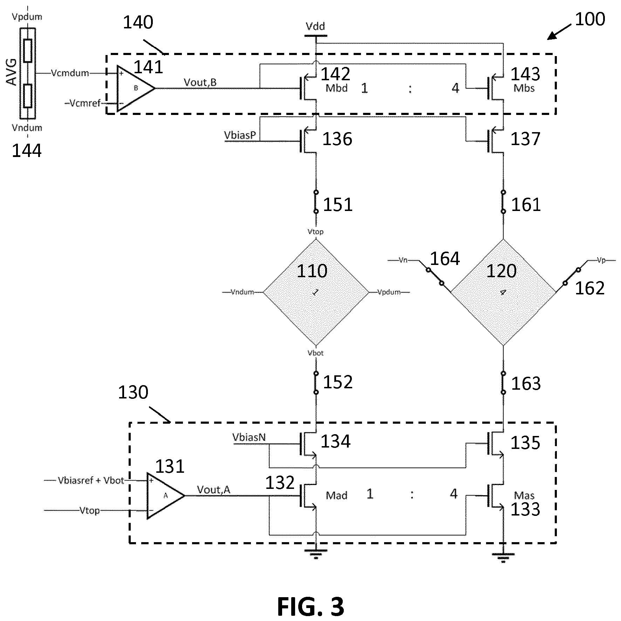

In the exemplary embodiment illustrated in FIG. 1 the signals Vout,A and Vout,B of the first operational amplifier 131 and the second operational amplifier 141 are used to drive a second transistor 133 and a fourth transistor 143 respectively. The second transistor 133 is connected between a bias contact of the at least one Hall plate 120 and the ground and the fourth transistor 143 is connected between another bias contact of the at least one Hall plate 120 and the supply voltage. There may also be switches present between any of the transistors (133, 143) and the at least one Hall plate 120 (see for example FIG. 3, FIG. 5 and FIG. 6). In this exemplary embodiment of the present invention the second 133 and fourth 143 transistor driving the sensor Hall plates are n times bigger than the first transistors 132 and the third transistor 142 respectively. The size may thereby be measured as the W/L ratio. They are connected with their drains to opposite contacts of n parallel hall plates (the n sensor hall plates) in a manner similar to transistors 132, 142 to opposite contacts of the dummy Hall plate transistor. n is the mirroring factor and can be any integer bigger than or equal to 1, although practical limitations will limit the maximum mirroring factor. As the sensing Hall plates are n, with n a positive integer (e.g. 4), in parallel their resistance is n times lower than that of a dummy Hall plate, if the dummy Hall plate is similar to the sensing Hall plates.

In this implementation the sensor Hall plates 120 biasing voltage Vbias will be the same as the dummy hall plate 110 biasing voltage Vbiasdum (and equal to the reference Vbiasref), also the common mode voltage Vcm of the sensor plates 120 will be the same as the dummy common mode voltage Vcmdum of the dummy plate 110 (and equal to the reference Vcmref). As such there will be a better matching between the dummy plate and the sensor plates compared to the prior art.

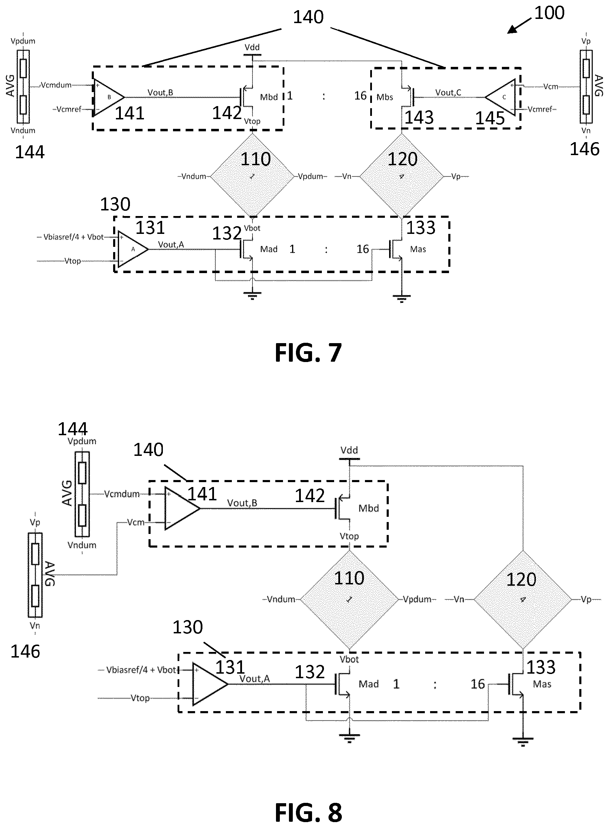

The idea of the implementation illustrated in FIG. 7 is to save current on the dummy Hall plate 110 as this Hall plate is not used for sensing. Only a quarter of the current is applied in the dummy Hall plate (Vbiasref/4). The Hall sensor is configured such that a factor of 1:16 is present between the current through the dummy Hall plate 110 and the current through the sensor Hall plates 120 (in the example there are four sensor Hall plates).

In this example an extra common mode regulator (comprising a third operational amplifier 145 and a fourth transistor 143) is required for the measuring Hall plates to generate the common mode of the measuring Hall plates separately. Since in this example the current through and voltage over the measuring Hall plates is different than the current through and voltage over the dummy resistive structure, an extra regulator is needed to regulate the common mode voltage of the measuring Hall plates separately. The disadvantage of this extra amplifier is that this will increase the total current consumption of the Hall device when the current consumption of this extra amplifier is bigger than the decrease in current in dummy Hall plate 110.

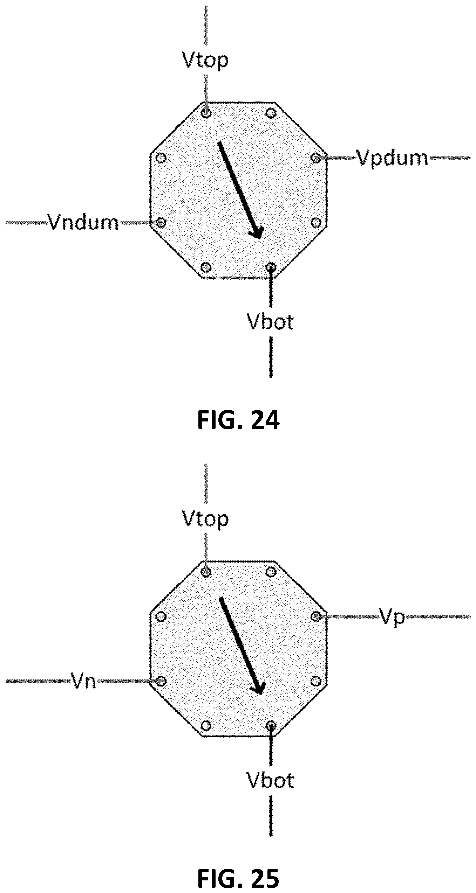

In FIG. 1 the dummy resistor structure 110 and the sensor structure are Hall plate structures with 4 contact Hall plates. For these Hall plates one pair of the contacts may be used as a bias contact pair and one pair of the contacts may be used as a sense contact pair. The number of contacts of the contact Hall plates is, however, not limited to 4. In another exemplary embodiment of the present invention this number may for example be 8. Such an example is shown in FIG. 2. An exemplary biasing and readout scheme for an 8 contact single dummy Hall plate is shown in FIG. 24. An exemplary biasing and readout scheme for an 8 contact single sensor Hall plate is shown in FIG. 25.

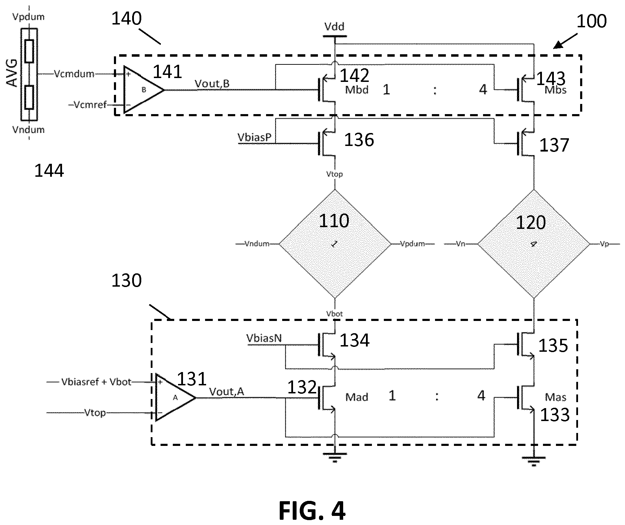

In embodiments of the present invention the transistors for driving the current through the at least one dummy Hall plate and/or through the at/least one sensor Hall plate may be configured in a cascode configuration. See for example FIG. 4 with bias transistor 134 in cascode with the first transistor 132 and electrically connected with the bottom node of the dummy resistor structure 110, and with bias transistor 136 in cascode with the third transistor 142 and electrically connected with the top node of the dummy resistor structure 110. Similarly, bias transistors 135 and 137 are connected with the top and bottom nodes of the sensor structure 120.

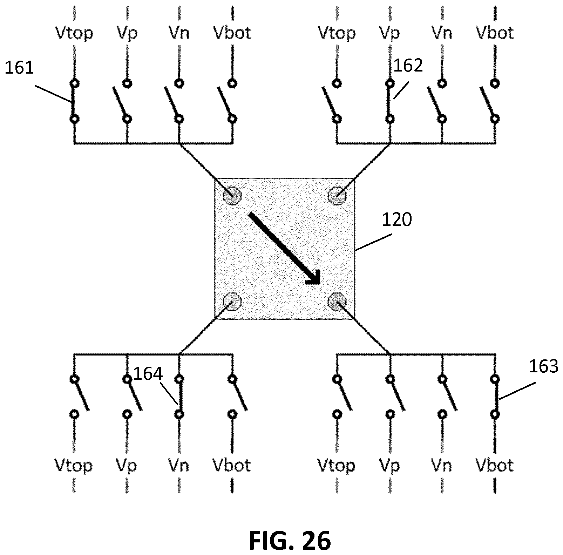

FIG. 3 also shows two switches 151, and 152 connected to the top and bottom node of the dummy resistor structure and switching circuitry comprising switches 161, 162, 163, 164 for spinning the sense contacts and the bias contacts of the sensor structure 120. These switches and spinning schemes implemented using these switches are further illustrated in FIG. 26 to 28. These switches are not strictly required. An exemplary embodiment of the present invention may for example be like the configuration in FIG. 3 without the switches (with the bias transistors directly connected to the top and bottom nodes; this is illustrated in FIG. 4). The switches 151, and 152 provide a switch resistance similar to switches 161 and 163. These switches 151, and 152 are in-fact dummy-switches not because they are connected to the dummy plates but because they don't need any switch-functionality in the context of the present invention.

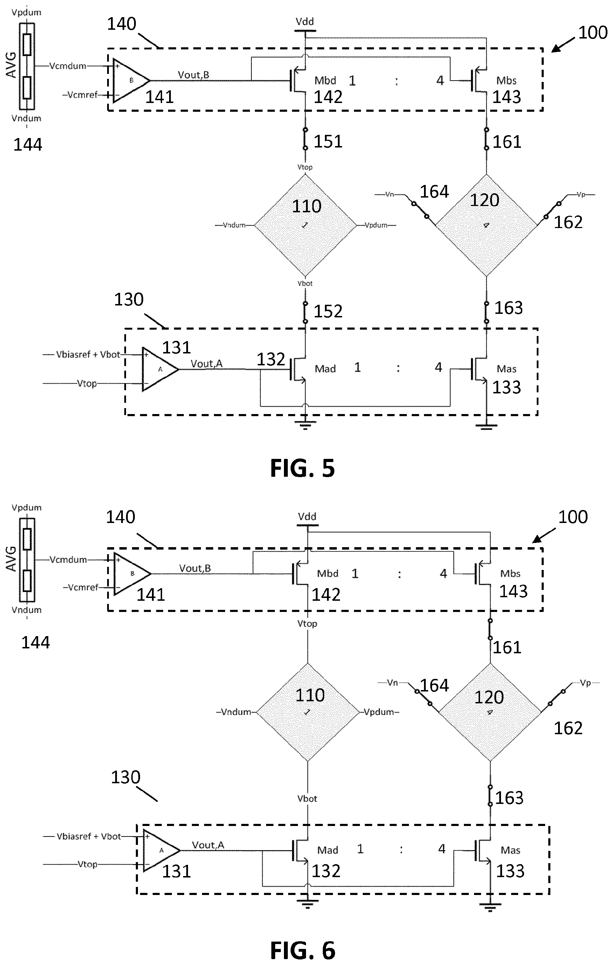

In yet another exemplary embodiment, illustrated in FIG. 5, of the present invention the additional cascode transistors 134, 135, 136, 137 are not present but the switches 151, 152, 161, 162, 163, 164 are.

In FIG. 6, only the spinning switches 161, 162, 163, 164, for spinning the sense contacts and the bias contacts of the sensor structure 120, are present.

This, i.e. the cascode configuration, is especially advantageous for driving the current to assure correct mirroring of the current. In case of only 1 nMOS transistor there would be a larger difference between the drain-source voltages of the dummy plate nMOS and the sensor plate nMOS.

In embodiments of the present invention the cascode transistors may also serve as switches of the hall plate switch matrix to minimize to total amount of transistors needed.

In the exemplary embodiment illustrated in FIG. 7 the biasing voltage Vbiasdum of the dummy plate is m times smaller than the biasing voltage Vbias of the sensor plates wherein m is the predefined scaling factor (this may for example be 2, in the illustrated exemplary embodiment m=4). This will result in dummy hall plate current which is also m times smaller than the current flowing through 1 of the n parallel sensor hall plates or m x n times smaller than the total sensor hall plate current (n is equal to 4 in the exemplary embodiment illustrated in FIG. 7). The goal was to save current consumption however an extra regulator (e.g. the third operational amplifier 145) is needed to regulate the common mode of the sensor hall plates separately. Nevertheless, this implementation is a viable solution as well.

Instead of connecting the gate of the fourth transistor 143 to Vout,B, it must be connected to Vout,C, the output of third operational amplifier 145 which works in a very similar fashion as regulator B, but connects Vcm instead of Vcmdum to its positive input. Vcm is the average of Vp and Vn. It is not necessary to have a seperate average block 146 as the combined functionality of the average block and regulator C can be done by a modified regulator with 2 positive inputs (Vp and Vn) and 1 negative input with double weight (Vcmref) such as for example illustrated in FIG. 16. It is important that the total regulator performs the following function:
Vout,C = Gc^{∗}((Vp+Vn)/2-Vcmref) = Gc^{∗}(Vcm-Vcmref), with Gc a high gain ( f.e. more than 60dB).

The fourth transistor 143 and the second transistor 133 are now m x n times bigger than the third transistor 142 and and the first transistor 132 respectively and the intended transfer function of the first operational amplifier 131 is now:
Vout,A = Ga^{∗}(Vbiasref/m-(Vtop-Vbot)), with Ga a high gain (f.e. more than 60dB). This is because the goal is to regulate Vbiasdum to Vbiasref/4 so that Vbias is still equal to Vbiasref.

In the example illustrated in FIG. 7, Hall plates with 4 contacts are used. The invention is, however, not limited thereto and also Hall plates with more than 4 contacts such as for example 8 contacts may be used such as for example is done in FIG. 2.

In the exemplary embodiment illustrated in FIG. 8, rather that regulating the common mode of the dummy Hall plate and the common mode of the measuring Hall plate separately, the common mode of the dummy Hall plate is regulated to the common mode of the sensing Hall plate. In this implementation the common mode may still be varying and is not fixed to Vcmref.

The exemplary embodiment illustrated in FIG. 8 is a variant of the embodiment illustrated in FIG. 7 where the fourth transistor 143 is removed. The top contacts of the sensor hall plates 120 are now connected directly to Vdd (Hall plates with 4 contacts or with more contacts, such as for example with 8 contacts may be used). Regulator B (i.e. the second operational amplifier 141) now regulates the dummy plate common mode Vcmdum to the common mode voltage of the sensor hall plates Vcm instead of a predefined reference level Vcmref. This is done because Vcm can no longer be regulated and it is important to have the same common mode for the sensor plate and the dummy plate. The common mode in this case will be approximately equal to VDD-Vbiasref/2 and will remain constant (if VDD and Vbiasref remains constant). The common mode voltage is not exactly equal to VDD-Vbiasref/2 due to the bulk source effect, which causes the resistivity of the hall structure to change over applied voltage. The negative input of regulator B (i.e. the second operational amplifier 141) is now connected to Vcm (average of Vp and Vn) instead of a reference Vcmref.

It is not necessary to have a seperate average block 144, 146 as the combined functionality of the 2 average blocks and regulator B can be done by a modified regulator with 2 positive inputs (Vpdum and Vndum) and 2 negative inputs (Vp and Vn). It is important that the total regulator performs the following function:
Vout,B = Gb^{∗}((Vpdum+Vndum)-(Vp+Vn))/2 = Gb^{∗}(Vcmdum-Vcm), with Gb a high gain ( f.e. more than 60dB).

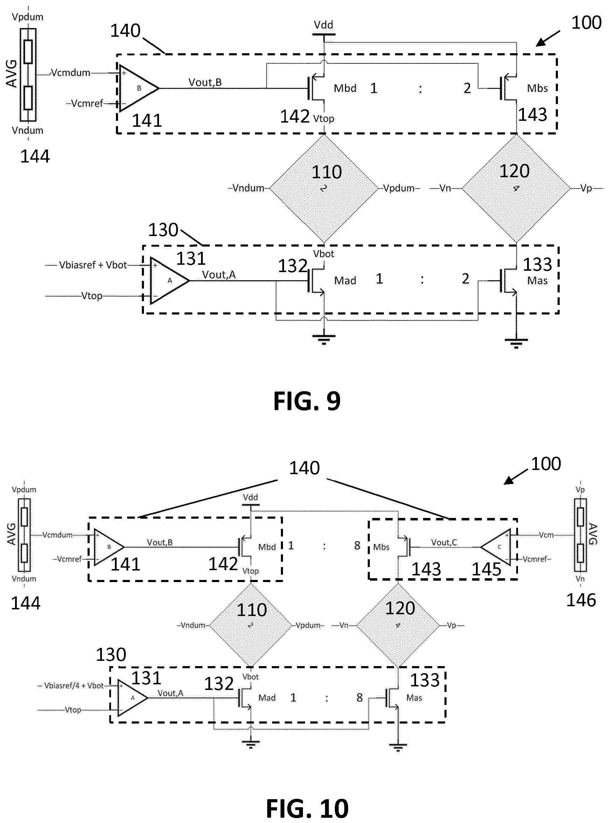

The implementations illustrated in FIG. 9 to 14 are implementations with 2 dummy hall plates, where the current in 1 of the 2 plates flows with a 90-degree orientation compared to the current in the other plate. In the examples illustrated in these figures the Hall plates are Hall plates with 4 contacts. Hall plates with more than 4 contacts, such as for example 8 contacts are also possible.

The implementation illustrated in FIG. 9 is similar to the implementation in FIG. 1 except with 2 dummy hall plates 110 in parallel (or anti-parallel) instead of just 1 dummy hall plate.

The implementation illustrated in FIG. 10 is similar to the implementation illustrated in FIG. 7 except with 2 dummy hall plates 110 in parallel (or anti-parallel) instead of just 1 dummy hall plate.

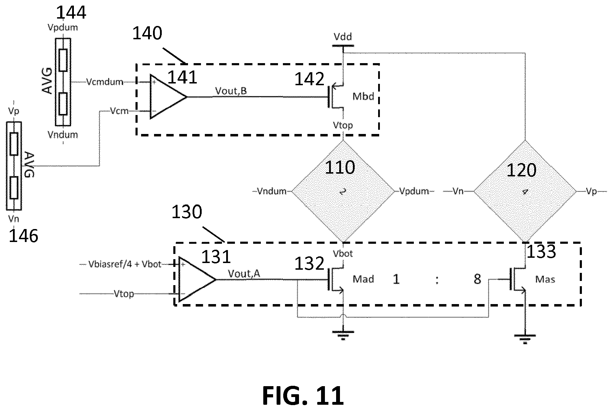

The implementation illustrated in FIG. 11 is similar to the implementation illustrated in FIG. 8 except with 2 dummy hall plates 110 in parallel (or anti-parallel) instead of just 1 dummy hall plate.

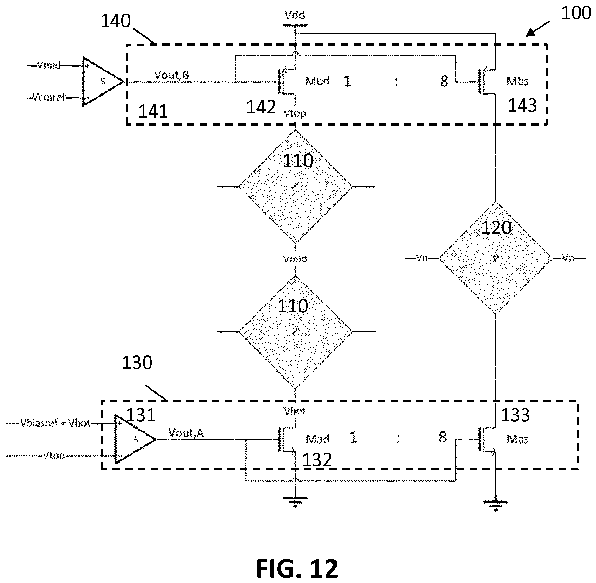

The implementation illustrated in FIG. 12 is similar to implementation illustrated in FIG. 1 except with 2 dummy hall plates 110 in series instead of just 1 dummy hall plate. The intermediate contact is between the two dummy Hall plates. During operation the voltage at this contact is Vmid. Vmid is used as positive input for amplifier 141 instead of Vcmdum.

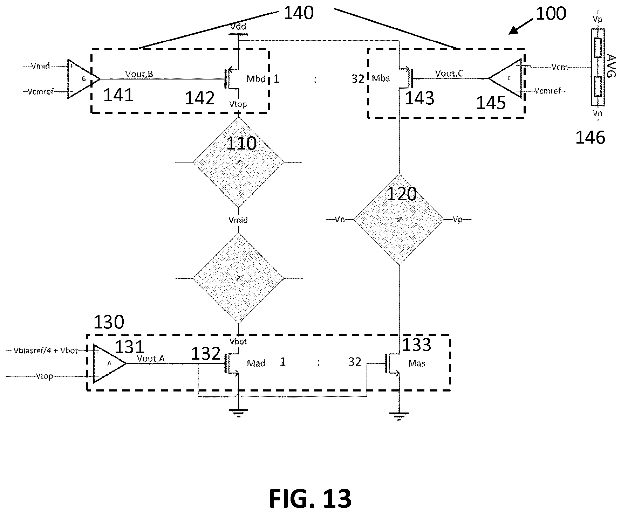

The implementation illustrated in FIG. 13 is similar to the implementation illustrated in FIG. 7 except with 2 dummy hall plates 110 in series instead of just 1 dummy hall plate.

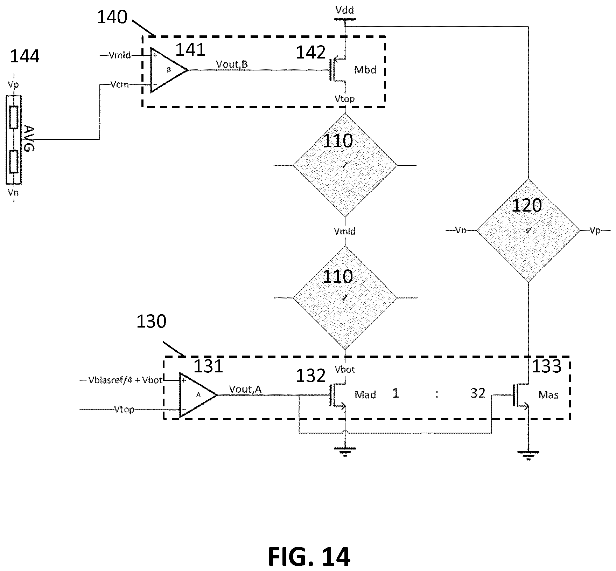

The implementation illustrated in FIG. 14 is similar to the implementation illustrated in FIG. 8 except with 2 dummy hall plates in series instead of just 1 dummy hall plate.

In the implementations illustrated in FIG. 9 to 11 the dummy plates are placed in parallel (or anti-parallel) and in the implementations illustrates in FIGs 12 to 14 the plates are put in series.

It is an advantage of embodiments of the present invention that 2 dummy plates are used in a 90 degree orientation instead of one, because 2 dummy plates in a 90 degree orientation cope better with stresses because of the 90 degree orientation.

In embodiments of the present invention also 4 dummy plates (or any multiple of 2) may be used.

In embodiments of the present invention all or some of the nMOS and pMOS transistors may be swapped. The common mode regulation can be done by a regulator at the bottom and the Vbias regulation by a regulator connected to the top of the Hall plates. This will result in the same functionality.

As already clear from the exemplary embodiments above, in embodiments of the present invention the dummy resistor structure may be a dummy hall plate.

In embodiments of the present invention the dummy resistor structure is a bridge resistive structure preferably made of the same material as the hall plate. It is advantageous that this dummy resistor structure behaves like the sensor hall plates (e.g. with respect to resistivity change over temperature and with respect to behavior to stress). Also, in the exemplary embodiments cited above another dummy resistor structure may be used than a dummy Hall plate.

In the exemplary embodiments illustrated in FIG. 1 to FIG. 14 the average block 144 for the dummy common mode regulation is drawn as an entity separate from the second regulator 140. This is, however, not strictly required. In embodiments of the present invention the average block 144 may be integrated in the regulating amplifier 141 of the second regulator. A simple amplifier (illustrated in FIG. 15) can be modified to the amplifier illustrated in FIG. 16.

The second regulator now has 2 positive and 2 negative inputs, the positive inputs are Vpdum and Vndum and the negative inputs are both connected to Vcmref. The amplifier is reacting on the sum (twice the common mode) of 2 inputs.

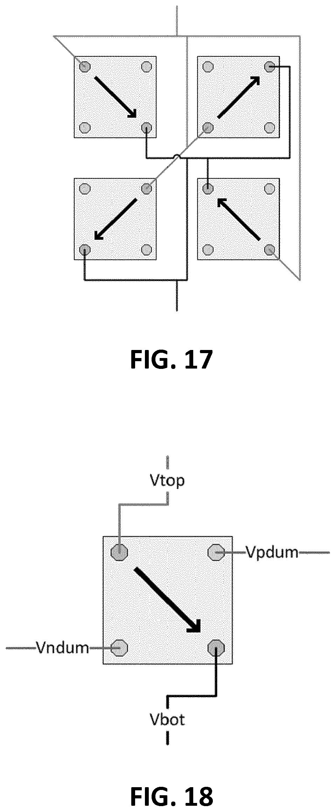

FIG. 17 shows 4 parallel sensing hall plates during 1 phase. The direction of the currents can be different as long as all 4 directions are done in an equal amount. It is also possible to use only 2 of the directions. In this last case it is important that the 2 directions have a 90 degree angle between them and not 180 degrees. For hall plates with more than 4 contacts (such as for example illustrated in FIG. 2) more than 4 directions are possible. In any of the figures 3 to 14 the four contact Hall plate may be replaced by an 8 contact Hall plate.

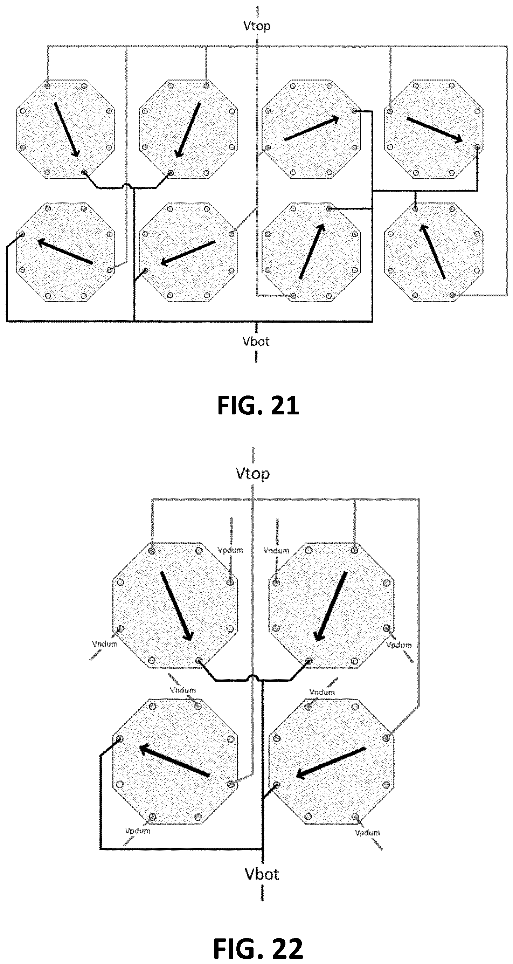

It is not necessary that the 4 hall plates from for example FIG. 17 are placed in a square (similar with the 8 contact plates, each with 8 contacts of FIG. 21). Instead they can be placed on a line or indeed any location.

In each phase the current direction for each plate changes but is is important that the same directions are used in total (for all plates)

In embodiments of the present invention the plates may be placed fully in parallel. This can for example be applied in the case where each plate sees the same field.

In embodiments of the present invention where f.e. an integrated magnetic concentrator (IMC) is used, the 2 Hall plates on the right could see a field with opposite sign as the 2 Hall plates on the left. In that case the Hall plates are preferably put in an anti-parallel configuration. Which means that sensing terminals 1 of the left plates should be connected to sensing terminals 2 of the right plates.

FIG. 18 shows a single dummy Hall plate with the biasing contacts (voltages Vtop, Vbot) and the sensing contacts (voltages Vndum, Vpdum)

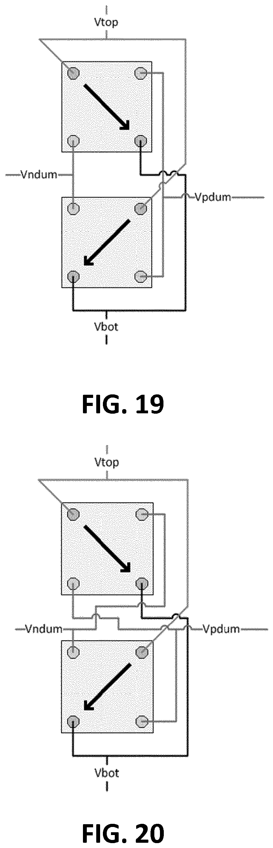

In case of 2 dummy resistor structures (e.g. 2 dummy Hall plates), they can either be placed fully in parallel such as illustrated in FIG. 19 or in anti-parallel such as illustrated in FIG. 20. In FIG. 19 the current in the 2 Hall plates flows in 2 directions with 90° difference. Their sensing nodes are shorted to the corresponding sensing nodes of the other plate. In FIG. 20 the current in the 2 Hall plates flows in 2 directions with 90° difference. Their sensing nodes are shorted to the opposite sensing nodes of the other plate.

The subsequent averaging of Vpdum and Vndum (for Vcmdum) is recommended in both cases, in an example not covered by the claims, it might not be needed in the case of anti-parallel since in the case of anti-parallel a positive terminal is shortened with a negative terminal causing the nets automatically to be, in an ideal world, the common mode and thus independent of the magnetic field.

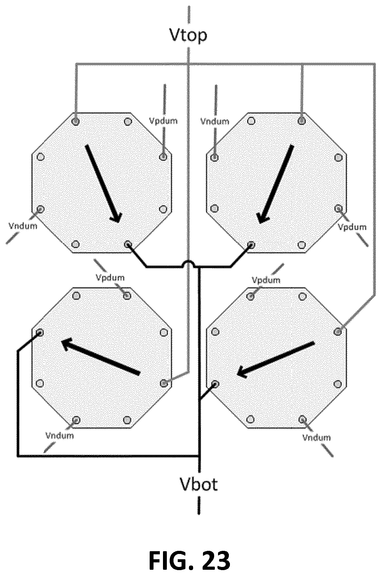

FIG. 22 shows a configuration of 4 dummy Hall plates (each with 8 contacts) connected in a parallel configuration. FIG. 23 shows a configuration of 4 dummy Hall plates (each with 8 contacts) connected in an anti-parallel configuration.

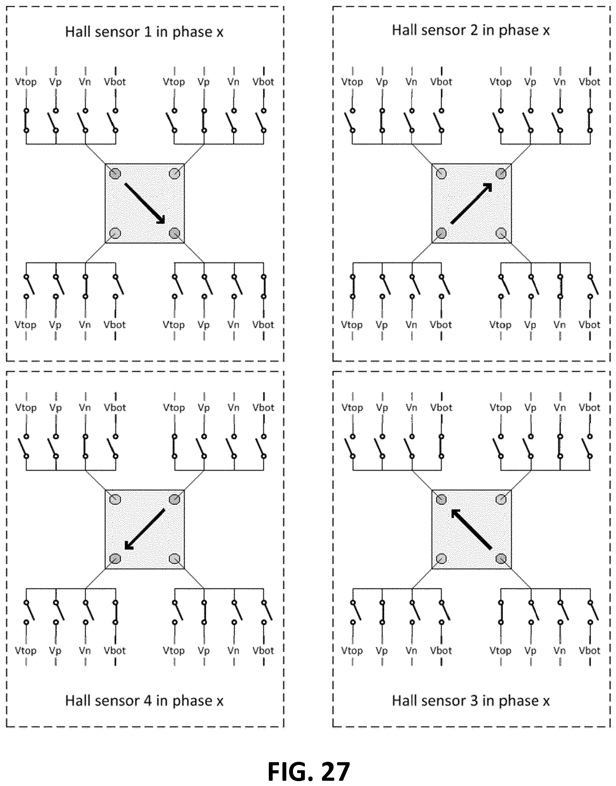

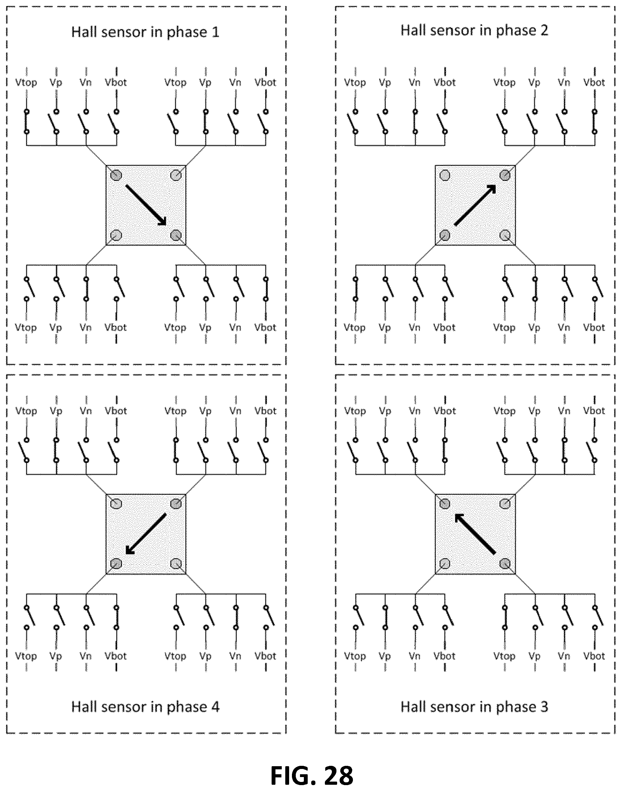

In embodiments of the present invention phase spinning may be applied on the sensor Hall plates. Extra spinning switches are needed in this case (see for example the switches 161, 162, 163, and 164 connected with the contacts of the sensor structure in FIG. 3, 5 and 6). FIG. 26 shows a more detailed schematic drawing of the switching circuitry comprising the switches 161 (connected to Vtop), 162 (connected to Vp), 163 (connected to Vbot), 164 (connected to Vn). Using this switching circuitry, it is possible to spin the sensor structure such that the contacts of the sensor structure are alternatingly bias contacts and sense contacts. In FIG. 27 is illustrated how spatial spinning can be implemented using such switching circuitry, and in FIG. 28 is illustrated how temporal spinning can be implemented using such switching circuitry.

Where in embodiments of the present invention reference is made to the normalized sensitivity of a sensor structure (e.g. a Hall plate), reference is made to the sensitivity of the sensor structure divided by the bias voltage of the sensor structure.

A hall plate, for example, has a certain sensitivity S expressed in mV per Tesla [mV/T]. The Hall plate sensitivity is approximately proportional to the bias voltage Vbias. Meaning that when f.e. Vbias = 2V, the sensitivity S is roughly 2 times higher than when Vbias = 1V. That is why the normalized sensitivity Sv is used. This is the sensitivity divided by the bias voltage and is expressed in mV per Volt per Tesla (mV/(VT)]. This is roughly constant over Vbias but not fully due to the bulk source effect.

It is normal that a dummy plate has a lower sensitivity as the sensor plate if the voltage over the dummy plate is significantly lower than the bias voltage of the sensor plates. If Vbiasdum is 4x smaller than Vbias, then the sensivity of the dummy plates is roughly 4x lower than the sensitivity of the sensor plates.

However, the normalized sensitivity Sv is roughly constant. And when the dummy plates and the sensor plates have the same common mode then Sv is the same. This is not the case when the CM is different.

## Claims

1. A bridge sensor (100) comprising at least one dummy resistor structure (110), at least one sensor structure (120), a first regulator (130), wherein the at least one sensor structure is a bridge magnetic sensor structure comprising two bias contacts and two sense contacts, and wherein the first regulator (130) is adapted to apply a predefined bias voltage between two bias contacts (Vtop, Vbottom) of the at least one dummy resistor structure (110) and to apply, to one of the bias contacts of the at least one sensor structure, a current having a value equal to the one of a current flowing at the corresponding bias contact of the at least one dummy resistor structure multiplied by a predefined factor,
**characterized in that** the bridge sensor comprises a second regulator (140) and that the at least one dummy resistor structure is a bridge resistive structure comprising two intermediate contacts between the two bias contacts of the at least one dummy resistor structure or comprising one intermediate contact between the two bias contacts of the at least one dummy resistor structure wherein the second regulator (140) is adapted to regulate a dummy common mode voltage (Vcmdum) being an average of voltages on the two intermediate contacts (Vndum, Vpdum) between the bias contacts (Vtop, Vbottom) of the at least one dummy resistor structure (110) or being a voltage on the intermediate contact (Vmid) between the bias contacts (Vtop, Vbottom) of the at least one dummy resistor structure (110) such that the dummy common mode voltage is the same as a common mode voltage being an average voltage of voltages on the sense contacts (Vn, Vp) of the at least one sensor structure (120).

2. A bridge sensor (100) according to claim 1 wherein the at least one dummy resistor structure (110) is made of the same material and/or using a same technology as the at least one sensor structure.

3. A bridge sensor (100) according to claim 1 wherein the sensor structure comprises switching circuitry (161, 162, 163, 164) adapted for spinning the sense contacts (Vn, Vp) and the bias contacts.

4. A bridge sensor (100) according to any of the previous claims wherein the second regulator (140) is adapted to regulate the common mode voltage to a predefined value.

5. A bridge sensor (100) according to any of the previous claims, wherein the first regulator (130) comprises a first operational amplifier (131), a first transistor (132) connected with a bias contact of the at least one dummy resistor structure (110) for biasing the at least one dummy resistor structure (110), and a second transistor (133) connected with a bias contact of the at least one sensor structure (120) for applying the current through one of the bias contacts of the at least one sensor structure (120) which has a value equal to the one of the current flowing at the corresponding bias contact of the at least one dummy resistor structure multiplied by the predefined factor, wherein gates of the first transistor (132) and of the second transistor (133) are controlled by an output of the first operational amplifier (131).

6. A bridge sensor according to any of the previous claims, wherein the second regulator (140) comprises a second operational amplifier (141), a third transistor (142) connected with a bias contact of the at least one dummy resistor structure (110) to regulate the dummy common mode voltage (Vcmdum)to the common mode voltage being the average voltage of voltages on the sense contacts (Vn, Vp) of the at least one sensor structure (120), wherein a gate of the third transistor (142) is controlled by an output of the second operational amplifier (141).

7. A bridge sensor according to any of the claims 1 to 5, wherein the second regulator (140) comprises a second operational amplifier (141), a third operational amplifier (145), a third transistor (142) connected with a bias contact of the at least one dummy resistor structure (110) to regulate the dummy common mode voltage (Vcmdum), and a fourth transistor (143) connected with a bias contact of the of the at least one sensor structure (120) to regulate the common mode voltage being the average voltage of voltages on the sense contacts (Vn, Vp) of the at least one sensor structure (120), wherein a gate of the third transistor (142) is controlled by an output of the second operational amplifier (141) and wherein a gate of the fourth transistor (143) is controlled by an output of the third operational amplifier (145).

8. A bridge sensor (100) according to any of the previous claims, the bridge sensor comprising a first average block (144) which is adapted for averaging the voltages on intermediate contacts of the dummy resistor structure (110) and outputting the obtained average and wherein the output of the average block (144) is connected with an input of the second regulator (140).

9. A bridge sensor (100) according to any of the previous claims, the bridge sensor comprising a second average block (146) which is adapted for averaging the voltages on the sense contacts (Vn, Vp) of the at least one sensor Hall plate (120) and outputting the obtained average and wherein the output of the second average block (146) is connected with an input of the second regulator (140).

10. A bridge sensor (100) according to any of the previous claims, wherein the at least one sensor structure (120) is a Hall plate.

11. A bridge sensor (100) according to claim 10, wherein the dummy resistor structure (110) comprises a dummy Hall plate (110), the dummy resistor structure having two intermediate contacts which are sense contacts (Vndum, Vpdum) of the dummy resistor structure (110).

12. A bridge sensor (100) according to claim 11, wherein the dummy resistor structure comprises two or more dummy Hall plates.

13. A bridge sensor (100) according to any of the previous claims wherein the number of sensor structures (120) is at least two.

14. A method for biasing a bridge sensor which comprises at least one dummy resistor (110) structure and at least one sensor structure (120), wherein the at least one sensor structure is a bridge magnetic sensor structure comprising two bias contacts and two sense contacts, the method comprising:
- applying a predefined bias voltage between two bias contacts (Vtop, Vbottom) of the at least one dummy resistor structure (110) and applying, to one of the bias contacts of the at least one sensor structure, a current having a value equal to the one of a current flowing at the corresponding bias contact of the at least one dummy resistor structure multiplied by a predefined factor,
**characterized in that** the method comprises:
- regulating a dummy common mode voltage (Vcmdum) being an average of voltages on at least two intermediate contacts (Vndum, Vpdum) of the at least one dummy resistor structure (110) or being a voltage on an intermediate contact (Vmid) between the bias contacts (Vtop, Vbottom) of the at least one dummy resistor structure (110), the at least one dummy resistor structure (110) being a bridge resistive structure comprising the two intermediate contacts between the two bias contacts of the at least one dummy resistor structure or comprising the one intermediate contact between the two bias contacts of the at least one dummy resistor structure, the regulating being such that the dummy common mode voltage is the same as a common mode voltage being an average of voltages on the sense contacts (Vn, Vp) of the at least one sensor structure.

## Patentansprüche

1. - Brückensensor (100), umfassend mindestens eine Blindwiderstandstruktur (110), mindestens eine Sensorstruktur (120), einen ersten Regler (130), wobei die mindestens eine Sensorstruktur eine magnetische Brückensensorstruktur ist, umfassend zwei Vorspannungskontakte und zwei Abtastkontakte, und wobei der erste Regler (130) angepasst ist, um eine vorher festgelegte Vorspannungsspannung zwischen zwei Vorspannungskontakten (Voben, Vunten) der mindestens einen Blindwiderstandstruktur (110) anzulegen und an einen der Vorspannungskontakte der mindestens einen Sensorstruktur einen Strom anzulegen mit einem Wert gleich dem eines Stroms, der an dem entsprechenden Vorspannungskontakt der mindestens einen Blindwiderstandstruktur fließt, multipliziert mit einem vordefinierten Faktor,
**dadurch gekennzeichnet, dass** der Brückensensor einen zweiten Regler (140) umfasst, und dass die mindestens eine Blindwiderstandstruktur eine resistive Brückenstruktur ist, umfassend zwei zwischenliegende Kontakte zwischen den zwei Vorspannungskontakten der mindestens einen Blindwiderstandstruktur oder umfassend einen zwischenliegenden Kontakt zwischen den zwei Vorspannungskontakten der mindestens einen Blindwiderstandstruktur, wobei der zweite Regler (140) angepasst ist, um eine Gleichtakt-Blindspannung (Vcmdum) zu regeln, die ein Durchschnitt von Spannungen an den zwei zwischenliegenden Kontakten (Vndum, Vpdum) zwischen den Vorspannungskontakten (Voben, Vunten) der mindestens einen Blindwiderstandstruktur (110) ist, oder eine Spannung an dem zwischenliegenden Kontakt (Vmid) zwischen den Vorspannungskontakten (Voben, Vunten) der mindestens einen Blindwiderstandstruktur (110) ist, sodass die Gleichtakt-Blindspannung die gleiche ist wie eine Gleichtaktspannung, die eine durchschnittliche Spannung von Spannungen an den Abtastkontakten (Vn, Vp) der mindestens einen Sensorstruktur (120) ist.

2. - Brückensensor (100) nach Anspruch 1, wobei die mindestens eine Blindwiderstandstruktur (110) aus dem gleichen Material und/oder unter Verwendung einer gleichen Technologie hergestellt ist wie die mindestens eine Sensorstruktur.

3. - Brückensensor (100) nach Anspruch 1, wobei die Sensorstruktur Umschalt-Schaltung (161, 162, 163, 164) umfasst, angepasst zum Drehen der Abtastkontakte (Vn, Vp) und der Vorspannungskontakte.

4. - Brückensensor (100) nach einem der vorstehenden Ansprüche, wobei der zweite Regler (140) angepasst ist, um die Gleichtaktspannung auf einen vordefinierten Wert zu regeln.

5. - Brückensensor (100) nach einem der vorstehenden Ansprüche, wobei der erste Regler (130) einen ersten betriebsfähigen Verstärker (131), einen ersten Transistor (132), verbunden mit einem Vorspannungskontakt der mindestens einen Blindwiderstandstruktur (110) zum Vorspannen der mindestens einen Blindwiderstandstruktur (110), und einen zweiten Transistor (133) umfasst, verbunden mit einem Vorspannungskontakt der mindestens einen Sensorstruktur (120) zum Anlegen des Stroms durch einen der Vorspannungskontakte der mindestens einen Sensorstruktur (120), der einen Wert gleich dem des Stroms aufweist, der an dem entsprechenden Vorspannungskontakt der mindestens einen Blindwiderstandstruktur fließt, multipliziert mit dem vordefinierten Faktor, wobei Gates des ersten Transistors (132) und des zweiten Transistors (133) durch eine Ausgabe des ersten betriebsfähigen Verstärkers (131) gesteuert werden.

6. - Brückensensor nach einem der vorstehenden Ansprüche, wobei der zweite Regler (140) einen zweiten betriebsfähigen Verstärker (141), einen dritten Transistor (142), verbunden mit einem Vorspannungskontakt der mindestens einen Blindwiderstandstruktur (110), umfasst, um die Gleichtakt-Blindspannung (Vcmdum) auf die Gleichtaktspannung zu regeln, die die durchschnittliche Spannung von Spannungen an den Abtastkontakten (Vn, Vp) der mindestens einen Sensorstruktur (120) ist, wobei ein Gate des dritten Transistors (142) durch eine Ausgabe des zweiten betriebsfähigen Verstärkers (141) gesteuert wird.

7. - Brückensensor nach einem der Ansprüche 1 bis 5, wobei der zweite Regler (140) einen zweiten betriebsfähigen Verstärker (141), einen dritten betriebsfähigen Verstärker (145), einen dritten Transistor (142), verbunden mit einem Vorspannungskontakt der mindestens einen Blindwiderstandstruktur (110), um die Gleichtakt-Blindspannung (Vcmdum) zu regeln, und einen vierten Transistor (143) umfasst, verbunden mit einem Vorspannungskontakt der mindestens einen Sensorstruktur (120), um die Gleichtaktspannung zu regeln, die die durchschnittliche Spannung von Spannungen an den Abtastkontakten (Vn, Vp) der mindestens einen Sensorstruktur (120) ist, wobei ein Gate des dritten Transistors (142) durch eine Ausgabe des zweiten betriebsfähigen Verstärkers (141) gesteuert wird und wobei ein Gate des vierten Transistors (143) durch eine Ausgabe des dritten betriebsfähigen Verstärkers (145) gesteuert wird.

8. - Brückensensor (100) nach einem der vorstehenden Ansprüche, wobei der Brückensensor einen ersten Durchschnittbildungsblock (144) umfasst, der zum Durchschnittbilden der Spannungen an zwischenliegenden Kontakten der Blindwiderstandstruktur (110) und Ausgeben des erhaltenen Durchschnitts angepasst ist, und wobei die Ausgabe des Durchschnittbildungsblocks (144) mit einer Eingabe des zweiten Reglers (140) verbunden ist.

9. - Brückensensor (100) nach einem der vorstehenden Ansprüche, wobei der Brückensensor einen zweiten Durchschnittbildungsblock (146) umfasst, der zum Durchschnittbilden der Spannungen an den Abtastkontakten (Vn, Vp) der mindestens einen Hall-Sensor-Platte (120) und Ausgeben des erhaltenen Durchschnitts angepasst ist, und wobei die Ausgabe des zweiten Durchschnittbildungsblocks (146) mit einer Eingabe des zweiten Reglers (140) verbunden ist.

10. - Brückensensor (100) nach einem der vorstehenden Ansprüche, wobei die mindestens eine Sensorstruktur (120) eine Hall-Platte ist.

11. - Brückensensor (100) nach Anspruch 10, wobei die Blindwiderstandstruktur (110) eine Blind-Hall-Platte (110) umfasst, wobei die Blindwiderstandstruktur zwei zwischenliegende Kontakte aufweist, die Abtastkontakte (Vndum, Vpdum) der Blindwiderstandstruktur (110) sind.

12. Brückensensor (100) nach Anspruch 11, wobei die Blindwiderstandstruktur zwei oder mehr Blind-Hall-Platten umfasst.

13. Brückensensor (100) nach einem der vorstehenden Ansprüche, wobei die Anzahl an Sensorstrukturen (120) mindestens zwei beträgt.

14. - Verfahren zum Vorspannen eines Brückensensors, der mindestens eine Blindwiderstand(110)-Struktur und mindestens eine Sensorstruktur (120) umfasst, wobei die mindestens eine Sensorstruktur eine magnetische Brückensensorstruktur ist, umfassend zwei Vorspannungskontakte und zwei Abtastkontakte, wobei das Verfahren umfasst:
- Anlegen einer vordefinierten Vorspannungsspannung zwischen zwei Vorspannungskontakten (Voben, Vunten) der mindestens einen Blindwiderstandstruktur (110) und Anlegen, an einen der Vorspannungskontakte der mindestens einen Sensorstruktur, eines Stroms mit einem Wert gleich dem eines Stroms, der durch den entsprechenden Vorspannungskontakt der mindestens einen Blindwiderstandstruktur fließt, multipliziert mit einem vordefinierten Faktor,
- °**dadurch gekennzeichnet, dass** das Verfahren umfasst:
- Regeln einer Gleichtakt-Blindspannung (Vcmdum), die ein Durchschnitt von Spannungen an mindestens zwei zwischenliegenden Kontakten (Vndum, Vpdum) der mindestens einen Blindwiderstandstruktur (110) ist oder eine Spannung an einem zwischenliegenden Kontakt (Vmid) zwischen den Vorspannungskontakten (Voben, Vunten) der mindestens einen Blindwiderstandstruktur (110) ist, wobei die mindestens eine Blindwiderstandstruktur (110) eine resistive Brückenstruktur ist, umfassend die zwei zwischenliegenden Kontakte zwischen den zwei Vorspannungskontakten der mindestens einen Blindwiderstandstruktur, oder umfassend den einen zwischenliegenden Kontakt zwischen den zwei Vorspannungskontakten der mindestens einen Blindwiderstandstruktur, wobei das Regeln so ist, dass die Gleichtakt-Blindspannung die gleiche ist wie eine Gleichtaktspannung, die ein Durchschnitt von Spannungen an den Abtastkontakten (Vn, Vp) der mindestens einen Sensorstruktur ist.

## Revendications

1. Capteur en pont (100) comprenant au moins une structure de résistance fictive (110), au moins une structure de capteur (120), un premier régulateur (130), dans lequel la au moins une structure de capteur est une structure de capteur magnétique en pont comprenant deux contacts de polarisation et deux contacts de détection, et dans lequel le premier régulateur (130) est adapté pour appliquer une tension de polarisation prédéfinie entre deux contacts de polarisation (Vtop, Vbottom) de la au moins une structure de résistance fictive (110) et pour appliquer, à l'un des contacts de polarisation de la au moins une structure de capteur, un courant présentant une valeur égale à celle d'un courant circulant au niveau du contact de polarisation correspondant de la au moins une structure de résistance fictive multipliée par un facteur prédéfini,
**caractérisé en ce que** le capteur en pont comprend un second régulateur (140) et **en ce que** la au moins une structure de résistance fictive est une structure résistive en pont comprenant deux contacts intermédiaires entre les deux contacts de polarisation de la au moins une structure de résistance fictive ou comprenant un contact intermédiaire entre les deux contacts de polarisation de la au moins une structure de résistance fictive dans lequel le second régulateur (140) est adapté pour réguler une tension de mode commun fictive (Vcmdum) qui est une moyenne des tensions sur les deux contacts intermédiaires (Vndum, Vpdum) entre les contacts de polarisation (Vtop, Vbottom) de la au moins une structure de résistance fictive (110) ou qui est une tension sur le contact intermédiaire (Vmid) entre les contacts de polarisation (Vtop, Vbottom) de la au moins une structure de résistance fictive (110) de sorte que la tension de mode commun fictive est identique à une tension de mode commun qui est une tension moyenne des tensions sur les contacts de détection (Vn, Vp) de la au moins une structure de capteur (120).

2. Capteur en pont (100) selon la revendication 1, dans lequel la au moins une structure de résistance fictive (110) est faite du même matériau et/ou utilise une technologie identique que la au moins une structure de capteur.

3. Capteur en pont (100) selon la revendication 1, dans lequel la structure de capteur comprend des circuits de commutation (161, 162, 163, 164) adaptés pour faire tourner les contacts de détection (Vn, Vp) et les contacts de polarisation.

4. Capteur en pont (100) selon l'une quelconque des revendications précédentes, dans lequel le second régulateur (140) est adapté pour réguler la tension de mode commun à une valeur prédéfinie.

5. Capteur en pont (100) selon l'une quelconque des revendications précédentes, dans lequel le premier régulateur (130) comprend un premier amplificateur opérationnel (131), un premier transistor (132) connecté à un contact de polarisation de la au moins une structure de résistance fictive (110) pour polariser la au moins une structure de résistance fictive (110), et un deuxième transistor (133) connecté à un contact de polarisation de la au moins une structure de capteur (120) pour appliquer le courant à travers l'un des contacts de polarisation de la au moins une structure de capteur (120) qui présente une valeur égale à celle du courant circulant au niveau du contact de polarisation correspondant de la au moins une structure de résistance fictive multipliée par le facteur prédéfini, dans lequel les grilles du premier transistor (132) et du deuxième transistor (133) sont commandées par une sortie du premier amplificateur opérationnel (131).

6. Capteur en pont selon l'une quelconque des revendications précédentes, dans lequel le second régulateur (140) comprend un deuxième amplificateur opérationnel (141), un troisième transistor (142) connecté à un contact de polarisation de la au moins une structure de résistance fictive (110) pour réguler la tension de mode commun fictive (Vcmdum) à la tension de mode commun qui est la tension moyenne des tensions sur les contacts de détection (Vn, Vp) de la au moins une structure de capteur (120), dans lequel une grille du troisième transistor (142) est commandée par une sortie du deuxième amplificateur opérationnel (141).

7. Capteur en pont selon l'une quelconque des revendications 1 à 5, dans lequel le second régulateur (140) comprend un deuxième amplificateur opérationnel (141), un troisième amplificateur opérationnel (145), un troisième transistor (142) connecté à un contact de polarisation de la au moins une structure de résistance fictive (110) pour réguler la tension de mode commun fictive (Vcmdum), et un quatrième transistor (143) connecté à un contact de polarisation de la au moins une structure de capteur (120) pour réguler la tension de mode commun qui est la tension moyenne des tensions sur les contacts de détection (Vn, Vp) de la au moins une structure de capteur (120), dans lequel une grille du troisième transistor (142) est commandée par une sortie du deuxième amplificateur opérationnel (141) et dans lequel une grille du quatrième transistor (143) est commandée par une sortie du troisième amplificateur opérationnel (145).

8. Capteur en pont (100) selon l'une quelconque des revendications précédentes, le capteur en pont comprenant un premier bloc de moyenne (144) qui est adapté pour calculer la moyenne des tensions sur des contacts intermédiaires de la structure de résistance fictive (110) et délivrer la moyenne obtenue et dans lequel la sortie du bloc de moyenne (144) est connectée à une entrée du second régulateur (140).

9. Capteur en pont (100) selon l'une quelconque des revendications précédentes, le capteur en pont comprenant un second bloc de moyenne (146) qui est adapté pour calculer la moyenne des tensions sur les contacts de détection (Vn, Vp) de la au moins une plaque de Hall de capteur (120) et délivrer la moyenne obtenue et dans lequel la sortie du second bloc de moyenne (146) est connectée à une entrée du second régulateur (140).

10. Capteur en pont (100) selon l'une quelconque des revendications précédentes, dans lequel la au moins une structure de capteur (120) est une plaque de Hall.

11. Capteur en pont (100) selon la revendication 10, dans lequel la structure de résistance fictive (110) comprend une plaque de Hall fictive (110), la structure de résistance fictive présentant deux contacts intermédiaires qui sont des contacts de détection (Vndum, Vpdum) de la structure de résistance fictive (110).

12. Capteur en pont (100) selon la revendication 11, dans lequel la structure de résistance fictive comprend deux ou plaques de Hall fictives ou plus.

13. Capteur en pont (100) selon l'une quelconque des revendications précédentes, dans lequel le nombre de structures de capteur (120) est d'au moins deux.

14. Procédé de polarisation d'un capteur en pont qui comprend au moins une structure de résistance fictive (110) et au moins une structure de capteur (120), dans lequel la au moins une structure de capteur est une structure de capteur magnétique en pont comprenant deux contacts de polarisation et deux contacts de détection, le procédé comprenant :
- l'application d'une tension de polarisation prédéfinie entre deux contacts de polarisation (Vtop, Vbottom) de la au moins une structure de résistance fictive (110) et l'application, à l'un des contacts de polarisation de la au moins une structure de capteur, d'un courant présentant une valeur égale à celle d'un courant circulant au niveau du contact de polarisation correspondant de la au moins une structure de résistance fictive multipliée par un facteur prédéfini,
- **caractérisé en ce que** le procédé comprend :
- la régulation d'une tension de mode commun fictive (Vcmdum) qui est une moyenne de tensions sur au moins deux contacts intermédiaires (Vndum, Vpdum) de la au moins une structure de résistance fictive (110) ou qui est une tension sur un contact intermédiaire (Vmid) entre les contacts de polarisation (Vtop, Vbottom) de la au moins une structure de résistance fictive (110), la au moins une structure de résistance fictive (110) étant une structure résistive en pont comprenant les deux contacts intermédiaires entre les deux contacts de polarisation de la au moins une structure de résistance fictive ou comprenant le premier contact intermédiaire entre les deux contacts de polarisation de la au moins une structure de résistance fictive, la régulation étant telle que la tension de mode commun fictive est identique à une tension de mode commun qui est une moyenne des tensions sur les contacts de détection (Vn, Vp) de la au moins une structure de capteur.
